# EUROPEAN PATENT SPECIFICATION

(11) **EP 4 588 090 B1**
(45) Date of publication and mention of the grant of the patent: **02.12.2026**
(21) Application number: 23764979.3
(22) Date of filing: 12.09.2023
(51) Int. Cl.: H01J 37/32, H01J 37/34, C23C 14/34, H03K 3/57, H03K 17/12

(54) **ENERGY REFEEDING MODULE, SWITCHING CIRCUIT AND EMBODIMENT, PLASMA PROCESSING SYSTEM, AND A METHOD OF PRODUCING RECTANGULAR VOLTAGE OUTPUT PULSES FOR A PLASMA PROCESSING LOAD**
ENERGIENACHSPEISEMODUL, SCHALTKREIS UND AUSFÜHRUNG, PLASMAVERARBEITUNGSSYSTEM UND VERFAHREN ZUR ERZEUGUNG VON IMPULSEN MIT RECHTECKIGER AUSGANGSSPANNUNG FÜR EINE PLASMAVERARBEITUNGSLAST
MODULE DE RÉALIMENTATION EN ÉNERGIE, CIRCUIT DE COMMUTATION ET MODE DE RÉALISATION, SYSTÈME DE TRAITEMENT PAR PLASMA ET PROCÉDÉ DE PRODUCTION D'IMPULSIONS DE TENSION DE SORTIE RECTANGULAIRE POUR UNE CHARGE DE TRAITEMENT PAR PLASMA

(30) Priority: 12.09.2022 EP 22460041
(43) Date of publication of application: 23.07.2025
(73) Proprietor: TRUMPF Huettinger Sp. z o.o., 05-220 Zielonka (PL)
(72) Inventor: KLIMCZAK, Andrzej, 01-633 Warsaw (PL); BALCERAK, Michal, 05-270 Marki (PL); GIERALTOWSKI, Andrzej, 02-786 Warsaw (PL)
(74) Representative: Trumpf Patentabteilung
(86) International application number: PCT/EP2023/074947
(87) International publication number: WO 2024/056624

(56) References cited:
- US-A1- 2009 316 438
- US-A1- 2019 157 044
- US-A1- 2021 408 917

## Description

The invention relates to an energy refeeding module, to a switching circuit comprising such an energy refeeding module, to a switching embodiment comprising at least one of such a switching circuit, a plasma system comprising such a switching circuit and/or a such switching embodiment, and method of producing rectangular voltage output pulses.

Some plasma treatment applications, such as etching or layer deposition, demand a high voltage (HV), high frequency (HF), rectangular, asymmetrical, pulsed voltage supply. Often the voltage values significantly exceed the voltage handling possibilities of individual semiconductor switches, especially when high frequency operation is required. Therefore, often series connection of such switches is the only possible solution. Series connection requires voltage balancing means. These are not easily realized in HF operation.

Most plasma applications present a load, which contains a capacitive component. Significant power loss is related to the pulse-by-pulse charging and discharging process of this load capacitance. Further problems are low efficiency of pulse generators and unwanted voltage oscillation. Therefore, voltage pulses are required which have an (almost) ideal rectangular shape.

In patent application US2021408917A1 are disclosed methods and systems for wafer biasing in a plasma chamber. A method include generating a first high voltage by a first pulsed voltage source using DC voltages and coupling the first high voltage to a wafer in the plasma chamber via at least one direct connection. In patent application US2019157044A1 is shown a high voltage, high frequency switching circuit. The switching circuit include a high voltage switching power supply that produces pulses having a voltage greater than 1 kV with frequencies greater than 10 kHz. The switching circuit also includes a resistive output stage electrically coupled in parallel with the output and between the output stage and the high voltage switching power supply.

In patent application US2009/316438A1 are disclosed a power supply arrangement and a transformer arrangement comprising a plurality of switched pulse generator sections. A switch control is connected to said plurality of switched pulse generator sections for providing control signals for turning on and/or turning off them. The switch control is arranged to provide control signals for turning on and/or turning off switched pulse generator sections of a first subset at a first time instant and to provide control signals for turning on and/or turning off switched pulse generator sections of a second subset at a second time instant, different from the first time instant. The second subset is different from the first subset.

It is the object of the present invention to provide an energy refeeding module, a switching circuit, switching embodiment, plasma processing system and a method for producing high voltage rectangular shape pulses.

The object is solved by an energy refeeding module according to claim 1 and/or a switching circuit according to claim 8 and/or a switching embodiment according to claim 11 and/or a plasma system according to claim 12 and/or a method according to claim 13. Further aspects of the invention are given in the dependent claims and / or the description.

According to one aspect of the invention an energy refeeding module is suggested for a switching circuit with a switching unit configured to be connectable to a DC voltage source and to deliver at its output one or a combination of the following features:
i) high value of voltage,
ii) high value of voltage rise,
iii) high current value to a capacitive load, in particular to a plasma processing load,
the energy refeeding module comprising:
a. a rectifying circuit configured to be connected with its positive end of its DC-side to the positive connection of the DC voltage source, with its negative end of its DC-side to the negative connection of the DC voltage source, in particular to ground potential, and
b. a transformer comprising:
   i. a primary winding configured to be connected in series between the switching unit and the output, and configured to have both, a stray inductance and parasitic resistance low enough to lead the one or a combination of the following features:
      - high value of voltage,
      - high value of voltage rise,
      - high current value
      and
   ii. a secondary winding connected to the AC-side of the rectifying circuit.

According to a further aspect of the invention a switching circuit is suggested, to be connected to a plasma processing load, comprising
- a series connection of a high-side-switching element and a low-side-switching element, the series connection being connected to a voltage source, and configured to generate a high voltage (HV) pulse signal at an output connectable to a plasma load,
- a rectifying circuit connected to the voltage source, and
- a transformer comprising:
   ∘ a primary winding connected in series between the output and a connection point between the high-side-switching element and the low-side-switching element, and
   ∘ a secondary winding connected to the rectifying circuit.

According to a further aspect of the invention a switching circuit is suggested configured to deliver high-voltage- (HV-) fast rising pulses to a plasma processing load, comprising:
a) a switching unit comprising a series connection of a high-side-switching element and a low-side-switching element, a connection point of both switching elements, a low side connection and a high side connection, the low side and high side connections connected to a voltage source,
b) an energy refeeding module as described here, with
   i. the rectifying circuit connected with its DC side to the voltage source, and
   ii. the primary winding of the transformer connected in series between the output and the connection point between the high-side-switching element and the low-side-switching element, and
   iii. the secondary winding connected to the AC-side of the rectifying circuit.

Such a switching circuit allows generating voltage pulses having nearly ideal rectangular shape. In particular, unwanted voltage oscillations can be prevented. Furthermore, the efficiency of such a switching circuit is very high. If such a switching circuit is used in a high voltage pulse generator, the efficiency of the pulse generator can be increased.

The stray inductance may be 100 µH or less. In particular 10 µH or less.

The parasitic resistance may be 1 Ω or less, in particular 0,1 Ω or less.

High value of voltage may be 800 V or more, in particular 1,5 kV or more, especially at least 5 kV.

High value of voltage rise may be a voltage rise of at least 1 kV/µs, in particular 10 kV/µs or more, preferred 100 kV/µs or more. With voltage rise could be meant voltage fall as well.

High current value may be at least 30 A, in particular 100 A or more.

High voltage pulse signal may be a pulse signal with a high voltage as defined above, in particular with a high value of voltage rise as defined above..

The module, the units, the circuit, and/or the embodiment may be configured for a power delivery into the plasma load, in particular during a pulse, at the output of at least 10 kW, advantageously 20 kW or more.

The rectifying circuit may be connected with its positive end of the DC-side to the positive connection of the DC voltage source, with its negative end of the DC-side to the negative connection of the DC voltage source, in particular to ground potential.

The energy refeeding module, the switching circuit, and/or the switching unit may be part of a high power generator as described in EP22461510.4, filed 28.02.2022, with the title "High power generator and method of supplying high power pulses".

The transformer may be a step-up transformer. During generating the pulse the high-side switching element switch may be switched on, so the energy from the voltage source flows to the output connectable to a load, in particular a plasma load having capacitive characteristics. At the beginning of this process almost the entire voltage difference between the voltage source and the voltage on the load occurs on the primary winding of the transformer. At the secondary winding of the transformer a voltage is induced. The value of this voltage is equal to the voltage at the primary winding multiplied by the transformer ratio. If this induced voltage is higher than the supply voltage on the busbar, the rectifying components of the rectifier start to conduct. In this way, the induced voltage at the secondary winding is limited to the value of the voltage on the busbar, i.e. the supply voltage. Because of the transformer ratio, also the voltage at the primary winding is reduced (to a voltage corresponding to the voltage on the busbar divided by the ratio of the transformer). Therefore, at the beginning of charging of the load the transformer represents a relatively low impedance and allows to quickly charge the load. In this state, the transformer's magnetic core does not accumulate any energy, which could cause overvoltage on the load.

When the charging current decreases such that the voltage induced at the secondary winding is not higher than the voltage on the busbar, the current in the secondary winding stops flowing so the transformer merely acts as an inductance. This inductance of the primary winding of the transformer increases, so the current charging the load capacitance decreases. Therefore the charging process decelerates, which reduces unwanted oscillations.

Basically the same occurs when the high-side-switching element is opened and the low-side switching element is closed, i.e. during the falling flank of the output voltage pulse. In that state the energy from the load capacitance is discharged through the low-side-switching element. At the beginning of this process the voltage at the primary winding of the transformer is high enough, that some energy is returned to the busbar by the rectifying circuit.

This process is relatively fast, as the current is limited mainly by the leakage inductance of the transformer. At the end of discharging the capacitive load, the voltage at the primary winding of the transformer is low (the voltage at the secondary winding of the transformer is lower than the voltage at the busbar), so the transformer starts to behave as an ordinary inductance that limits the current and decelerates the discharging process of the load. Once again, the unwanted oscillation is relatively small because the amount of energy stored in the inductance of the transformer is small.

Because for some time some energy is returned back to the busbar and thus to the power source during charging and discharging load capacitance, this circuit has an increased overall efficiency.

The rectifying circuit may comprise one component configured to lead current only in one way, in particular a rectifying diode.

The rectifying circuit may comprise two components configured to lead current only in one way, in particular two rectifying diodes.

The rectifying circuit may comprise four components configured to lead current only in one way, in particular four rectifying diodes, in particular in a bridge circuit. In this way the rectifying circuit can be realized with cheap standard components.

An overvoltage-protecting unit, in particular an overvoltage-protecting diode, may be configured to be connected between the output and the rectifier circuit in order to protect the load against overvoltage.

At least one overvoltage-protecting unit, in particular one overvoltage-protecting diode, may be configured to be connected between the output and at least one connection of the voltage source.

As it was mentioned before, the transformer is charging itself. Therefore, it stores some energy. This can generate some overvoltage (the load capacitance would be charged to a voltage higher than that of the busbar). To avoid this, this overvoltage-protecting unit, in particular overvoltage-protecting diode, can be provided, which protects the load against overvoltage. In this way, unwanted oscillations can be prevented. A first damping resistor may be connected in series to the overvoltage-protecting unit. With that, the energy refeeding module may be even better stabilized. The first damping resistor may have a value from 1 Ω to 100 Ω, preferably from 20 Ω to 70 Ω.

A negative-voltage-protecting unit, in particular a negative-voltage-protecting diode, may be configured to be connected between the output and the ground potential in order to protect the load from negative voltage. Moreover, unwanted oscillations can be limited by adding such a a negative-voltage-protecting unit, in particular a negative-voltage-protecting diode parallel to the load which prevents the load from charging to a negative voltage. A second damping resistor may be connected in series to the negative-voltage-protecting unit. With that, the energy refeeding module may be further stabilized. The second damping resistor may have a value from 1 Ω to 100 Ω, preferably from 20 Ω to 70 Ω.

A diode may be connected in parallel to one, in particular to each of the switching elements. Such, the switching elements may be protected against high voltages. This is particularly true if the switching elements comprise MOSFETS as switching parts. Each switching element may comprise one or more switching parts, for example MOSFETs or bipolar transistors.

One aspect of the invention relates to a switching embodiment with
a. several switching units as described in this description above, comprising in particular a series connection of a high-side-switching element and a low-side-switching element, a connection of both switching elements, a low side connection and a high side connection, the low side and high side connections connected to a voltage source, and
b. at least one switching circuit as described in this description above,
where the switching units are connected in series with one voltage source connection point of one switching circuit connected to the output of the next switching circuit in the series connection line.

A further aspect of the invention relates to a plasma system comprising a plasma load and a switching circuit as described in this description above, and/or a switching embodiment described in this description above. Such a plasma system may be used advantageously in semiconductor production processes, in particular for production of 3D- memory devices, such as 3D NAND-memory devices, preferred when etching deep holes for connection of the 3D-structure.

A further aspect of the invention relates to a method of producing rectangular voltage output pulses with the energy refeeding module described in the description above, comprising the steps of:
- generating a HV pulse signal at an output of a switching circuit using a series connection of a high-side-switching element and a low-side-switching element, the series connection being connected to a voltage source,
- providing the HV pulse signal at the output via a primary winding of a transformer,
- rectifying a current induced in a secondary winding of the transformer.

This method allows generating voltage pulses having nearly ideal rectangular shape. Voltage overshoots and oscillations can be prevented, thus increasing efficiency.

During charging and discharging of a load capacitance connected to the output, energy is fed back to the busbar. This increases the efficiency of the switching circuit. Power loss can largely be prevented.

Oscillations may be reduced by providing diodes connected to the output.

More precise, the oscillations may be reduced by providing
a. an overvoltage-protecting unit, in particular an overvoltage-protecting diode, and/or
b. a negative-voltage-protecting unit, in particular a negative-voltage-protecting diode connected to the output (OUT),
and in particular further reduced by a first and/or a second damping resistor connected in series to the protecting units, in particular the diodes, respectively. Further features and advantages of the invention result from the following detailed description of embodiments of the invention on the basis of the figures of the drawing, which show details essential to the invention, as well as from the claims. The features shown there are not necessarily to be understood as being to scale and are shown in such a way that the special features according to the invention can be made clearly visible. The various features can be implemented individually or in any combination in variants of the invention.

In the schematic drawing, examples of the invention in various stages of use are shown and explained in more detail in the following description.
- Fig. 1: shows a first example of a plasma processing system with a switching circuit and with an energy refeeding module,
- Fig. 2: shows an output voltage obtained with the inventive switching circuit,
- Fig. 3a, 3b 4a, 4b: show additional examples of a plasma processing systems each with series combination of switching circuits comprising one or several energy refeeding modules,
- Fig 5a: shows the pictures of Fig. 1 and Fig 2 together in a simplified presentation
- Fig 5b - 5d: show related possibilities of Fig. 5a.

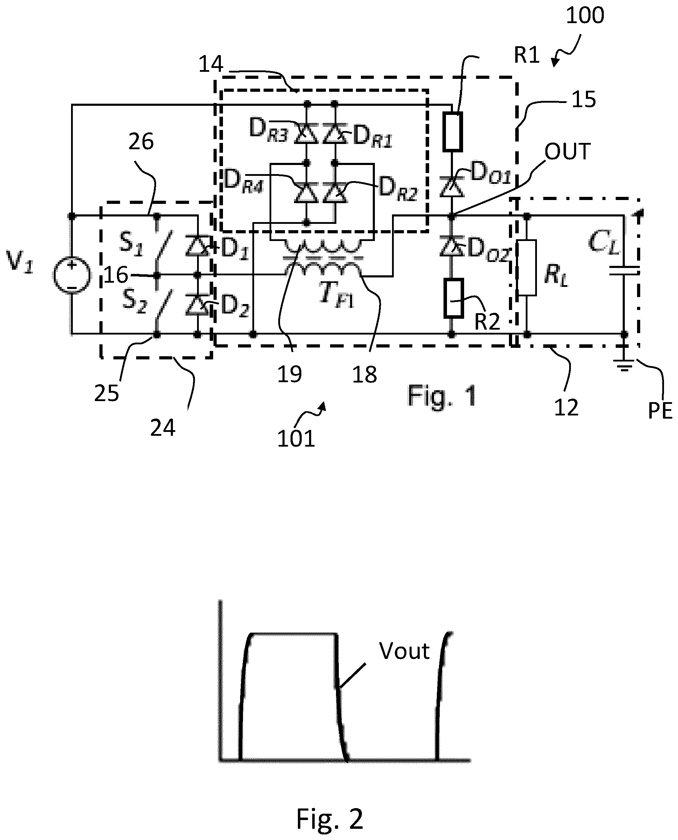

Fig. 1 shows a first example of a plasma processing system 100 with a plasma processing load 12, a switching circuit 101 comprising an energy refeeding module 15 and a switching unit 24 both connected to a DC voltage source V1. The switching circuit 101 is configured to deliver at its output OUT a high value of voltage, high value of voltage rise and/or high current value to a capacitive load, in particular to a plasma processing load 12. The plasma processing load 12 comprises a resistive component R_{L} and a capacitive component C_{L}. A typical value for the resistive component R_{L} is a value between 0,5 kΩ and 50 kΩ. A typical value for the capacitive component C_{L} is a value between 0,1 µF and 1 µF. This may be a plasma load similar or identical as described in the European Patent Application with the application number EP22461510.4, filed 28.02.2022, with the title "High power generator and method of supplying high power pulses". The plasma processing system 100 described here may be similar or identical as the one described in Fig. 10 of EP22461510.4, e.g.. The switching unit 24 comprises a series connection of a high-side-switching element S1 and a low-side-switching element S2 and may be similar or identical as the switching units 24, 26, 28 in EP22461510.4. The switching unit 24 may be connected with its positive end 26 to the positive connection of the DC voltage source V1 and with its negative end 25 to the negative connection of the DC voltage source V1, in particular to ground potential PE.

The switching circuit 101 further comprises an energy refeeding module 15. The energy refeeding module 15 is connected with its positive end to the positive connection of the DC voltage source V1 and with its negative end to the negative connection of the DC voltage source V1. The energy refeeding module 15 is further connected to the connection point 16 between the high-side-switching element S1 and the low-side-switching element S2. The energy refeeding module 15 is further connected with the output OUT of the switching circuit 101.

The energy refeeding module 15 comprises a rectifying circuit 14 and a transformer TF1. The rectifying circuit 14 is connected with its positive end of the DC-side to the positive connection of the DC voltage source V1 and with its negative end of the DC-side to the negative connection of the DC voltage source V1, here in particular to ground potential PE. The transformer TF1 comprises a primary winding 18 and a secondary winding 19. The primary winding 18 is connected in series between the output OUT of the switching circuit 101 and the switching unit 24, in particular the connection point 16 between the high-side-switching element S1 and the low-side-switching element S2. The transformer TF1 is configured to have both, a stray inductance and parasitic resistance low enough to lead the afore mentioned high value of voltage, high value of voltage rise, and/or high current value. The secondary winding 19 of the transformer TF1 is connected with both ends to the AC-side of the rectifying circuit 14. The rectifying circuit 14 comprises four diodes DR1-DR4 connected here in a bridge circuit. The rectifying circuit 14 is connected with its DC-side to the voltage source V1 and with its AC-side to a secondary winding of a transformer TF1. The transformer TF1 may comprise a magnetic core.

Diodes D1, D2 are provided in parallel to each of the switching elements S1, S2. They may be used as freewheeling diodes and/or to protect the switching elements S1, S2 against negative voltage.

An overvoltage protection unit, embodied as a further diode D01, is connected between the output OUT and the positive connection of the voltage source V1 to protect the load against overvoltage. A negative-voltage-protecting unit, embodied as an other diode D02, is connected between the negative connection of the voltage source V1, here in particular ground potential PE, and the output OUT, i.e. in parallel to the load 12, in order to protect the load from negative voltages. These diodes D01, D02 may also reduce oscillations. Further, a first damping resistor R1 is connected in series with the overvoltage protection unit, embodies as diode D01. Further, a second damping resistor R2 is connected in series with the negative-voltage-protecting unit, embodied as diode D02. With these resistors oscillations may be reduced even better.

The operation of the switching circuit 101 is as follows. During generating of a pulse, high-side switching element S1 may be switched on so that energy from the voltage source V1 flows to the output OUT. At the beginning of this process almost the entire voltage difference between the voltage source V1 and the voltage on the load 12 occurs on the primary winding of the transformer TF1. Therefore, a voltage will be induced at the secondary winding 19 of the transformer TF1. The value of this voltage is equal to the voltage at the primary winding multiplied by the transformer ratio. If this induced voltage is higher than the voltage on the voltage source V1, the positively biased diodes DR1-DR4 of the rectifier 14 start to conduct, therefore the induced voltage at the secondary winding is limited to the value of the voltage of the voltage source V1. Because of the transformer ratio, also the voltage at the primary winding is reduced, to a voltage corresponding to the voltage on the voltage source V1 divided by the ratio of the transformer. Therefore, at the beginning of charging of the load 12 the transformer TF1 represents a relatively low impedance and allows to quickly charge the load 12. In this state, the transformer's magnetic core does not accumulate any energy, which may cause overvoltage on the load 12.

When the charging current decreases such that the voltage induced by the secondary winding is not higher than the voltage on the busbar V1, the current in the secondary winding stops flowing, so the transformer TF1 merely acts as an inductance. This inductance of the primary winding of transformer TF1 increases, so the current charging the load 12 decreases. Therefore, the charging process decelerates which reduces unwanted oscillations.

The same occurs when high-side switching element S1 is opened and low-side switching element 2 is closed, i.e. during the falling flank of the output voltage pulse. In that state the energy from the load is discharged through low-side switching element S2. At the beginning of this process the voltage at the primary winding of the transformer TF1 is high enough, that some energy is returned to the voltage source V1 by the rectifying circuit 14.

This process is relatively fast, as the current is limited mainly by the leakage inductance of the transformer TF1. At the end of discharging the load, the voltage at the primary winding of the transformer TF1 is low (the voltage at the secondary winding of the transformer TF1 is lower than the voltage at the voltage source V1). So, the transformer TF1 starts to behave as an ordinary inductance that limits the current and decelerates the discharging process of the load 12. Once again, the unwanted oscillation is relatively small because the amount of energy stored in the inductance of the transformer TF1 is small. Fig. 2 shows a voltage waveform VOUT generated by switching circuit 101 at its output OUT. As can be seen, a rectangular voltage pulse is obtained, having steep flanks and no oscillations at the corners of the pulse shape.

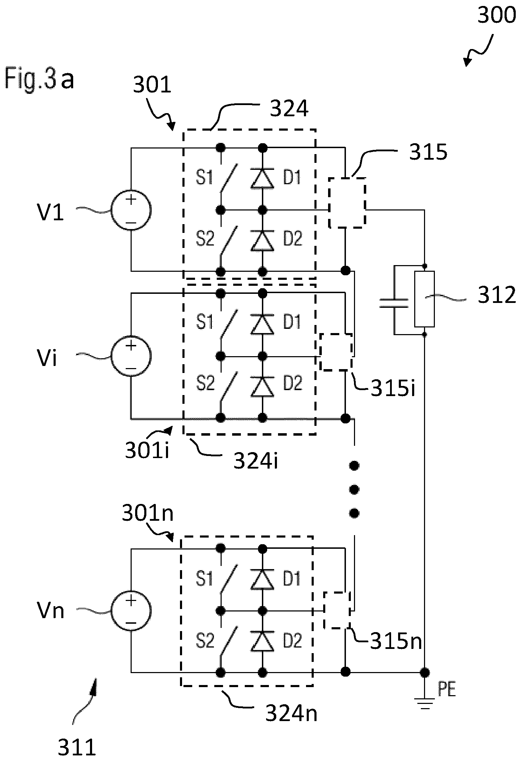

Fig. 3a shows a second example of a plasma processing system 300 with series combination of switching circuits 301, 301i,... 301n comprising an energy refeeding module 315, 315i,... 315n, and a switching unit 324,... 324i, 324n, each.

Every switching unit 324, 324i,... 324n, is connected to a corresponding voltage source V1, Vi,... Vn, respectively.

The series combination of switching circuits 301, 301i,... 301n may build a switching embodiment 311.

The switching units 324, ... 324i, ... 324n are connected in series with one voltage source connection point of one switching circuit 301, 301i connected to the output OUT of the next switching circuit 301i, 301n in the series connection line. The refeeding modules 315i,... 315n are here optional. For the effect only one refeeding module 315 at the output of the switching embodiment 311 may be sufficient.

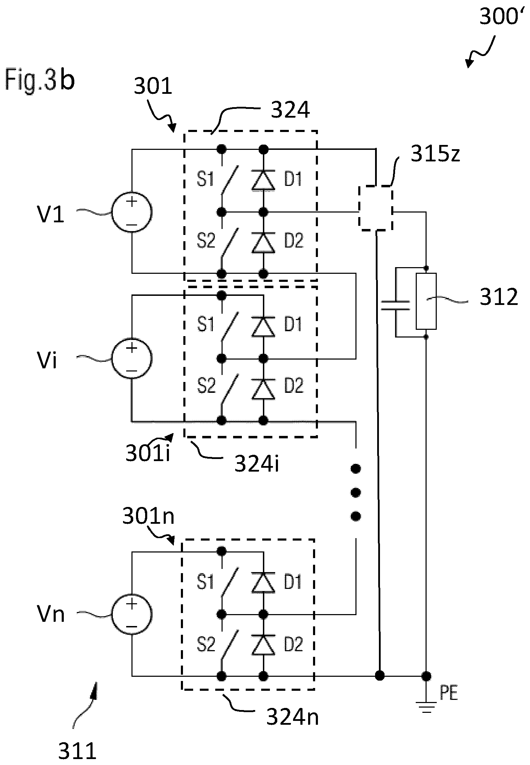

Fig. 3b shows a third example of a plasma processing system 300' with series combination of switching circuits 301, 301i,... 301n. In comparison to Fig. 3a the plasma processing system 300' comprises only one energy refeeding module 315z which is connected to the output of one of the switching circuits 301, to a voltage source V1 of a switching circuit 301, in particular to this switching circuit 301, and to a different voltage source Vn of a switching circuit 301n, in particular to ground potential PE.

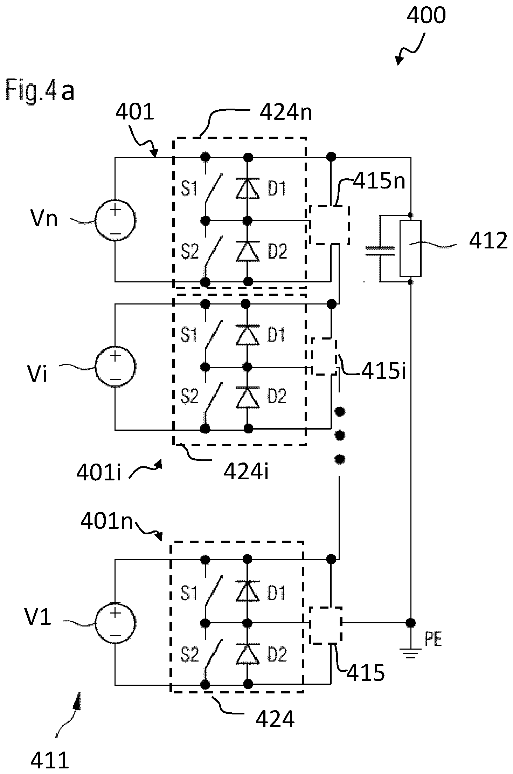

Fig. 4a shows a fourth example of a plasma processing system 400 with series combination of switching circuits 401, 401i,... 401n comprising an energy refeeding module 415, 415i,... 415n, and a switching unit 424,... 424i, 424n, each.

Every switching unit 424, 424i,... 424n, is connected to a corresponding voltage source V1, Vi,... Vn, respectively.

The series combination of switching circuits 401, 401i,... 401n may build a switching embodiment 411.

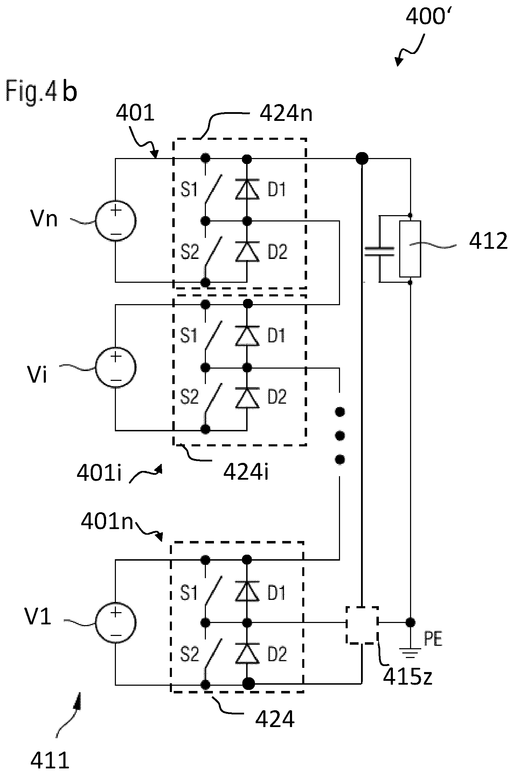

The switching units 424, ... 424i, ... 424n are connected in series with one voltage source connection point of one switching circuit 401n, 401i connected to the output OUT of the next switching circuit 401i, 401 in the series connection line. The refeeding modules 415i,... 415n are here optional. For the effect only one refeeding module 415 at the output of the switching embodiment 411 may be sufficient. A switching embodiment 411 with such a realization is shown in Fig. 4b, where the plasma processing system 400' has only one energy refeeding module 415z.

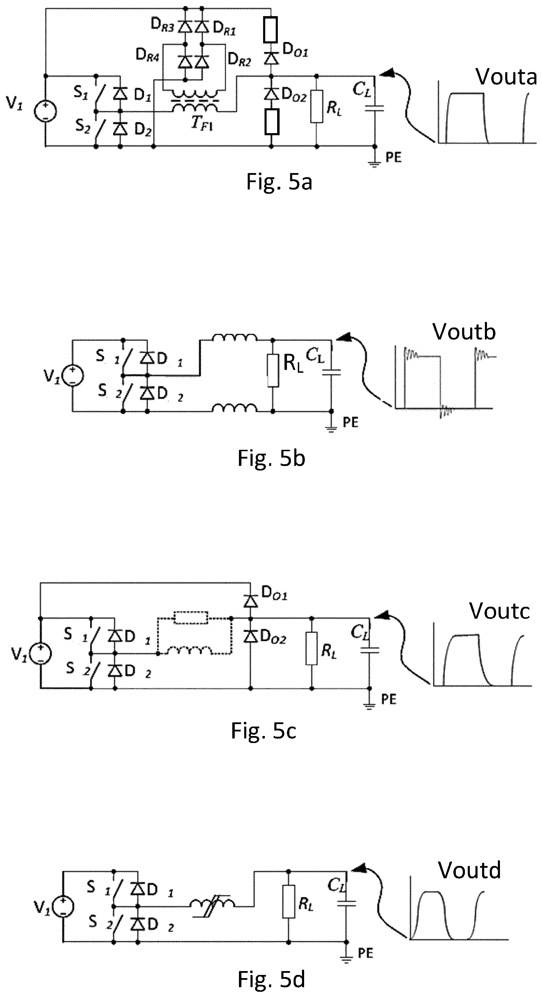

In Fig 5a - 5d the advantage of the energy refeeding module 15, 315, 415, the switching circuit 24, 324, 424 comprising such an energy refeeding module, the switching embodiment 311, 411 comprising at least one of such a switching circuit 324, 424, the plasma system 100, 300, 400 comprising such a switching circuit and/or a such switching embodiment, and the method of producing rectangular voltage output pulses should become more visible.

Fig 5a shows the pictures of Fig. 1 and Fig 2 together in a simplified presentation. Fig 5b - 5d show related possibilities of Fig. 5a with corresponding output voltages Voutb, Voutc, Voutd. The voltage swing may be of about 8 kV or more. The current, which is not shown, at the same time may be of about 30 A or more. The duration of such a pulse may be of 0,5 µs up to 2 µs. So, the rise times of the voltage may be about 300 ns or shorter. It can easily be seen that Vouta rises much faster than the voltages Voutc, Voutd in the corresponding circuits and systems of Fig. 5c and Fig. 5d. So, the module, circuit, embodiment, and system of Fig. 5a has advantages compared to the circuits in Fig 5c and Fig. 5d. Further, it can easily be seen that Vouta rises not faster than the voltages Voutb in the corresponding circuits and systems of Fig. 5b. But, the voltage Voutb in Fig. 5b shows a significant overvoltage swing, which the voltage Vouta does not show in Fig. 5a. So, the module, circuit, embodiment, and system of Fig. 5a has advantages related to fast switching with reduced overshoot and reduced oscillations compared also to the circuit in Fig 5b.

## Claims

1. Energy refeeding module (15) for
a switching circuit (101) with a switching unit (24) configured to be connectable to a DC voltage source (V1) and to deliver at its output (OUT) one or a combination of the following features:
i) high value of voltage,
ii) high value of voltage rise,
iii) high current value to a capacitive load, in particular to a plasma processing load (12),
the energy refeeding module (15) comprising:
a. a rectifying circuit (14) configured to be connected with its positive end of its DC-side to the positive connection of the DC voltage source (V1), with its negative end of its DC-side to the negative connection of the DC voltage source (V1), in particular to ground potential (PE), and
b. a transformer (TF1) comprising:
i. a primary winding (18) configured to be connected in series between the switching unit (24) and the output (OUT), and configured to have both, a stray inductance and parasitic resistance low enough to lead the one or a combination of the following features:
- high value of voltage,
- high value of voltage rise,
- high current value
and
ii. a secondary winding (19) connected to the AC-side of the rectifying circuit (14).

2. Energy refeeding module (15) according to claim 1, wherein the transformer (TF1) is a step-up transformer.

3. Energy refeeding module (15) according to any of the preceding claims, wherein the rectifying circuit (14) comprises two components configured to lead current only in one way, in particular two rectifying diodes (DR1, DR3), in particular four components configured to lead current only in one way, in particular four rectifying diodes (DR1-DR4), in particular in a bridge circuit.

4. Energy refeeding module (15) according to any of the preceding claims, wherein an overvoltage-protecting unit, in particular overvoltage-protecting diode (D01) is configured to be connected between the output (OUT) and the positive end of the DC-Side of the rectifier circuit (14) in order to protect the load (12) against overvoltage.

5. Energy refeeding module (15) according to claim 4 with a first damping resistor R1 connected in series with the overvoltage-protecting unit.

6. Energy refeeding module (15) according to any of the preceding claims, wherein a negative-voltage-protecting unit, in particular a negative-voltage-protecting diode (D02), is configured to be connected between the output (OUT) and the negative connection of the DC voltage source (V1) in particular to ground potential (PE), in order to protect the load (12) from negative voltage.

7. Energy refeeding module (15) according to claim 6 with a second damping resistor (R2) connected in series with the negative-voltage- -protecting unit.

8. Switching circuit (101, 301, 401) configured to deliver high-voltage- (HV-) fast rising pulses to a plasma processing load (12), comprising:
a. a switching unit (24) comprising a series connection of a high-side-switching element (S1) and a low-side-switching element (S2), a connection point (16) of both switching elements (S1, S2), a low side connection (25) and a high side connection (26), the low side and high side connections (25, 26) connected to a DC voltage source (V1),
b. an energy refeeding module (15) of one of the preceding claims, with
i. the rectifying circuit (14) connected with its DC side to the DC voltage source (V1), and
ii. the primary winding (18) of the transformer (TF1) connected in series between the output (OUT) and the connection point (16) between the high-side-switching element (S1) and the low-side-switching element (S2), and
iii. the secondary winding (19) connected to the AC-side of the rectifying circuit (14).

9. Switching circuit (101, 301, 401) according to claim 8, wherein a diode (D1, D2) is connected in parallel to one, in particular to each, of the switching elements (S1, S2).

10. Switching circuit (101, 301, 401) according to any of the preceding claims 8 or 9, wherein at least one overvoltage-protecting unit, in particular one diode (D01, D02), is connected between the output (OUT) and at least one connection of the DC voltage source (V1).

11. Switching embodiment (311, 411) with
a. several switching units (324, ... 324i, ... 324n, 425, ...324i, ...324n) according to feature a. of claim 8, and
b. at least one switching circuit (301) according to one of the preceding claims 8 - 10,
c. where the switching units (324, ... 324i, ... 324n, 424 ...424i, ...424n) are connected in series with one voltage source connection point of one switching circuit (301, 301i, 401i, 401n) connected to the output (OUT) of the next switching circuit (301i, 301n, 401, 401i) in the series connection line.

12. Plasma system (100, 300, 400) comprising a plasma load (12, 312, 412) and
a. a switching circuit (101, 301, 401) according to one of the preceding claims 8 - 10, and/or
b. a switching embodiment (311, 411) according to claim 11.

13. Method of producing rectangular voltage output pulses (Vout) for a plasma processing load (12) with an energy refeeding module (15) according to any of the preceding claims, the method comprising the steps of
a. Generating a high- voltage- (HV-) pulse signal at an output (OUT) of a switching circuit (10) using a series connection of a high-side-switching element (S1) and a low-side-switching element (S2), the series connection being connected to a voltage source (V1),
b. Providing the HV pulse signal at the output (OUT) via a primary winding of a transformer (TF1),
c. rectifying a current induced in a secondary winding of the transformer (TF1).

14. Method according to claim 13, wherein during charging and discharging of a load capacitance connected to the output (OUT), energy is fed back to the busbar.

15. Method according to one of the claims 13 or 14, wherein oscillations are reduced by providing
a. an overvoltage-protecting unit, in particular an overvoltage-protecting diode (D01), and/or
b. a negative-voltage-protecting unit, in particular a negative-voltage-protecting diode (D02) connected to the output (OUT), and
in particular further reduced by a first and/or a second damping resistor (R1, R2) connected in series to the protecting units, in particular the diodes (D01, D02), respectively.

## Patentansprüche

1. Energienachspeisemodul (15) für
einen Schaltkreis (101) mit einer Schalteinheit (24), die so konfiguriert ist, dass sie an eine Gleichspannungsquelle (V1) anschließbar ist und an ihrem Ausgang (OUT) eines oder eine Kombination der folgenden Merkmale liefert:
i) hohen Spannungswert,
ii) hohen Wert des Spannungsanstiegs,
iii) hohen Stromwert an eine kapazitive Last, insbesondere an eine Plasmaverarbeitungslast (12),
wobei das Energienachspeisemodul (15) umfasst:
a. einen Gleichrichterkreis (14), der so konfiguriert ist, dass er mit seinem positiven Ende seiner Gleichspannungsseite an den positiven Anschluss der Gleichspannungsquelle (V1) und mit seinem negativen Ende seiner Gleichspannungsseite an den negativen Anschluss der Gleichspannungsquelle (V1), insbesondere an Erdpotential (PE), angeschlossen ist, und
b. einen Transformator (TF1), umfassend:
i. eine Primärwicklung (18), die so konfiguriert ist, dass sie in Reihe zwischen der Schalteinheit (24) und dem Ausgang (OUT) geschaltet ist, und so konfiguriert ist, dass sowohl eine Streuinduktivität als auch ein parasitärer Widerstand niedrig genug sind, um zu dem einen oder einer Kombination der folgenden Merkmale zu führen:
- hohen Spannungswert,
- hohen Wert des Spannungsanstiegs,
- hohen Stromwert
und
ii. eine Sekundärwicklung (19), die an die Wechselspannungsseite des Gleichrichterkreises (14) angeschlossen ist.

2. Energienachspeisemodul (15) nach Anspruch 1, wobei der Transformator (TF1) ein Aufwärtstransformator ist.

3. Energienachspeisemodul (15) nach einem der vorhergehenden Ansprüche, wobei der Gleichrichterkreis (14) zwei Komponenten umfasst, die so konfiguriert sind, dass sie Strom nur in eine Richtung leiten, insbesondere zwei Gleichrichterdioden (DR1, DR3), insbesondere vier Komponenten, die so konfiguriert sind, dass sie Strom nur in eine Richtung leiten, insbesondere vier Gleichrichterdioden (DR1-DR4), insbesondere in einer Brückenschaltung.

4. Energienachspeisemodul (15) nach einem der vorhergehenden Ansprüche, wobei eine Überspannungsschutzeinheit, insbesondere eine Überspannungsschutzdiode (D01), so konfiguriert ist, dass sie zwischen dem Ausgang (OUT) und dem positiven Ende der Gleichspannungsseite des Gleichrichterkreises (14) angeschlossen ist, um die Last (12) vor Überspannung zu schützen.

5. Energienachspeisemodul (15) nach Anspruch 4 mit einem ersten Dämpfungswiderstand R1, der in Reihe mit der Überspannungsschutzeinheit geschaltet ist.

6. Energienachspeisemodul (15) nach einem der vorhergehenden Ansprüche, wobei eine Negativspannungsschutzeinheit, insbesondere eine Negativspannungsschutzdiode (D02), so konfiguriert ist, dass sie zwischen dem Ausgang (OUT) und dem negativen Anschluss der Gleichspannungsquelle (V1), insbesondere dem Erdpotential (PE), angeschlossen ist, um die Last (12) vor negativer Spannung zu schützen.

7. Energienachspeisemodul (15) nach Anspruch 6 mit einem zweiten Dämpfungswiderstand (R2), der in Reihe mit der Negativspannungsschutzeinheit geschaltet ist.

8. Schaltkreis (101, 301, 401), der so konfiguriert ist, dass er Hochspannungs(HV)-Impulse mit schnellem Anstieg an eine Plasmaverarbeitungslast (12) liefert, umfassend:
a. eine Schalteinheit (24), die eine Reihenschaltung aus einem Oberspannungsschaltelement (S1) und einem Unterspannungsschaltelement (S2), einen Verbindungspunkt (16) beider Schaltelemente (S1, S2), einen Unterspannungsanschluss (25) und einen Oberspannungsanschluss (26) umfasst, wobei der Unterspannungs- und der Oberspannungsanschluss (25, 26) mit einer Gleichspannungsquelle (V1) verbunden sind,
b. ein Energienachspeisemodul (15) nach einem der vorhergehenden Ansprüche, wobei
i. der Gleichrichterkreis (14) mit seiner Gleichspannungsseite an die Gleichspannungsquelle (V1) angeschlossen ist und
ii. die Primärwicklung (18) des Transformators (TF1) in Reihe zwischen dem Ausgang (OUT) und dem Verbindungspunkt (16) zwischen dem Oberspannungsschaltelement (S1) und dem Unterspannungsschaltelement (S2) geschaltet ist und
iii. die Sekundärwicklung (19) an die Wechselspannungsseite des Gleichrichterkreises (14) angeschlossen ist.

9. Schaltkreis (101, 301, 401) nach Anspruch 8, wobei eine Diode (D1, D2) parallel zu einem, insbesondere zu jedem, der Schaltelemente (S1, S2) angeschlossen ist.

10. Schaltkreis (101, 301, 401) nach einem der vorhergehenden Ansprüche 8 oder 9, wobei mindestens eine Überspannungsschutzeinheit, insbesondere eine Diode (D01, D02), zwischen dem Ausgang (OUT) und mindestens einem Anschluss der Gleichspannungsquelle (V1) angeschlossen ist.

11. Schaltausführung (311, 411) mit
a. mehreren Schalteinheiten (324, ... 324i, ... 324n, 425, ...324i, ...324n) gemäß Merkmal a. von Anspruch 8 und
b. mindestens einem Schaltkreis (301) nach einem der vorhergehenden Ansprüche 8-10,
c. wobei die Schalteinheiten (324, ... 324i, ... 324n, 424 ...424i, ...424n) in Reihe geschaltet sind, wobei ein Spannungsquellenverbindungspunkt eines Schaltkreises (301, 301i, 401i, 401n) an den Ausgang (OUT) des nächsten Schaltkreises (301i, 301n, 401, 401i) in der Reihenschaltung angeschlossen ist.

12. Plasmasystem (100, 300, 400), umfassend eine Plasmalast (12, 312, 412) und
a. einen Schaltkreis (101, 301, 401) nach einem der vorhergehenden Ansprüche 8-10 und/oder
b. eine Schaltausführung (311, 411) nach Anspruch 11.

13. Verfahren zur Erzeugung von Impulsen mit rechteckiger Ausgangsspannung (Vout) für eine Plasmaverarbeitungslast (12) mit einem Energienachspeisemodul (15) nach einem der vorhergehenden Ansprüche, wobei das Verfahren die Schritte umfasst
a. Generieren eines Hochspannungs(HV)-Impulssignals an einem Ausgang (OUT) eines Schaltkreises (10) unter Verwendung einer Reihenschaltung aus einem Oberspannungsschaltelement (S1) und einem Unterspannungsschaltelement (S2), wobei die Reihenschaltung an eine Spannungsquelle (V1) angeschlossen ist,
b. Bereitstellen des HV-Impulssignals am Ausgang (OUT) über eine Primärwicklung eines Transformators (TF1),
c. Gleichrichten eines in einer Sekundärwicklung des Transformators (TF1) induzierten Stroms.

14. Verfahren nach Anspruch 13, wobei während des Ladens und Entladens einer an den Ausgang (OUT) angeschlossenen Lastkapazität Energie in die Sammelschiene zurückgespeist wird.

15. Verfahren nach einem der Ansprüche 13 oder 14, wobei Schwingungen reduziert werden durch Bereitstellen
a. einer Überspannungsschutzeinheit, insbesondere einer Überspannungsschutzdiode (D01), und/oder
b. einer Negativspannungsschutzeinheit, insbesondere einer Negativspannungsschutzdiode (D02), die an den Ausgang (OUT) angeschlossen ist, und
insbesondere weiter reduziert werden durch einen ersten und/oder einen zweiten Dämpfungswiderstand (R1, R2), die jeweils in Reihe zu den Schutzeinheiten, insbesondere den Dioden (D01, D02), geschaltet sind.

## Revendications

1. Module de réalimentation en énergie (15) pour
un circuit de commutation (101) avec une unité de commutation (24) configurée pour pouvoir être connectée à une source de tension CC (V1) et pour fournir, à sa sortie (OUT), une des caractéristiques suivantes ou une combinaison de celles-ci :
i) valeur élevée de tension,
ii) valeur élevée d'élévation de tension,
iii) valeur élevée de courant à une charge capacitive, en particulier à une charge de traitement par plasma (12),
le module de réalimentation en énergie (15) comprenant :
a. un circuit de redressement (14) configuré pour être connecté par son extrémité positive de son côté CC à la connexion positive de la source de tension CC (V1), par son extrémité négative de son côté CC à la connexion négative de la source de tension CC (V1), en particulier au potentiel de terre (PE), et
b. un transformateur (TF1) comprenant :
i. un enroulement primaire (18) configuré pour être connecté en série entre l'unité de commutation (24) et la sortie (OUT), et configuré pour avoir à la fois une inductance parasite et une résistance parasite suffisamment faibles pour conduire l'une des caractéristiques suivantes ou la combinaison de celles-ci :
- valeur élevée de tension,
- valeur élevée d'élévation de tension,
- valeur élevée de courant
et
ii. un enroulement secondaire (19) connecté au côté CA du circuit de redressement (14).

2. Module de réalimentation en énergie (15) selon la revendication 1, dans lequel le transformateur (TF1) est un transformateur élévateur.

3. Module de réalimentation en énergie (15) selon l'une quelconque des revendications précédentes, dans lequel le circuit de redressement (14) comprend deux composants configurés pour conduire le courant dans un seul sens, en particulier deux diodes de redressement (DR1, DR3), en particulier quatre composants configurés pour conduire le courant dans un seul sens, en particulier quatre diodes de redressement (DR1-DR4), en particulier dans un circuit en pont.

4. Module de réalimentation en énergie (15) selon l'une quelconque des revendications précédentes, dans lequel une unité de protection contre les surtensions, en particulier une diode de protection contre les surtensions (D01), est configurée pour être connectée entre la sortie (OUT) et l'extrémité positive du côté CC du circuit de redressement (14) afin de protéger la charge (12) contre les surtensions.

5. Module de réalimentation en énergie (15) selon la revendication 4 avec une première résistance d'amortissement R1 connectée en série avec l'unité de protection contre les surtensions.

6. Module de réalimentation en énergie (15) selon l'une quelconque des revendications précédentes, dans lequel une unité de protection contre les tensions négatives, en particulier une diode de protection contre les tensions négatives (D02), est configurée pour être connectée entre la sortie (OUT) et la connexion négative de la source de tension CC (V1) en particulier au potentiel de terre (PE), afin de protéger la charge (12) contre une tension négative.

7. Module de réalimentation en énergie (15) selon la revendication 6 avec une seconde résistance d'amortissement (R2) connectée en série avec l'unité de protection contre les tensions négatives.

8. Circuit de commutation (101, 301, 401) configuré pour fournir des impulsions haute tension (HT) à montée rapide à une charge de traitement par plasma (12), comprenant :
a. une unité de commutation (24) comprenant une connexion en série d'un élément de commutation côté haut (S1) et d'un élément de commutation côté bas (S2), un point de connexion (16) des deux éléments de commutation (S1, S2), une connexion côté bas (25) et une connexion côté haut (26), les connexions côté bas et côté haut (25, 26) étant connectées à une source de tension CC (V1),
b. un module de réalimentation en énergie (15) selon l'une des revendications précédentes, avec
i. le circuit de redressement (14) connecté par son côté CC à la source de tension CC (V1), et
ii. l'enroulement primaire (18) du transformateur (TF1) connecté en série entre la sortie (OUT) et le point de connexion (16) entre l'élément de commutation côté haut (S1) et l'élément de commutation côté bas (S2), et
iii. l'enroulement secondaire (19) connecté au côté CA du circuit de redressement (14).

9. Circuit de commutation (101, 301, 401) selon la revendication 8, dans lequel une diode (D1, D2) est connectée en parallèle à l'un des éléments de commutation (S1, S2), en particulier à chacun d'eux.

10. Circuit de commutation (101, 301, 401) selon l'une quelconque des revendications précédentes 8 ou 9, dans lequel au moins une unité de protection contre les surtensions, en particulier une diode (D01, D02), est connectée entre la sortie (OUT) et au moins une connexion de la source de tension CC (V1).

11. Mode de réalisation de commutation (311, 411) avec
a. plusieurs unités de commutation (324, ... 324i, ... 324n, 425, ...324i, ...324n) selon la caractéristique a. de la revendication 8, et
b. au moins un circuit de commutation (301) selon l'une des revendications précédentes 8 à 10,
c. où les unités de commutation (324, ... 324i, ... 324n, 424 ...424i, ...424n) sont connectées en série avec un point de connexion de source de tension d'un circuit de commutation (301, 301i, 401i, 401n) connecté à la sortie (OUT) du circuit de commutation (301i, 301n, 401, 401i) suivant dans la ligne de connexion en série.

12. Système au plasma (100, 300, 400) comprenant une charge de plasma (12, 312, 412) et
a. un circuit de commutation (101, 301, 401) selon l'une des revendications précédentes 8 à 10, et/ou
b. un mode de réalisation de commutation (311, 411) selon la revendication 11.

13. Procédé de production d'impulsions de tension de sortie rectangulaires (Vout) pour une charge de traitement par plasma (12) avec un module de réalimentation en énergie (15) selon l'une quelconque des revendications précédentes, le procédé comprenant les étapes de
a. génération d'un signal d'impulsion haute tension (HT) au niveau d'une sortie (OUT) d'un circuit de commutation (10) en utilisant une connexion en série d'un élément de commutation côté haut (S1) et d'un élément de commutation côté bas (S2), la connexion en série étant connectée à une source de tension (V1),
b. fourniture du signal d'impulsion HV à la sortie (OUT) par l'intermédiaire d'un enroulement primaire d'un transformateur (TF1),
c. redressement d'un courant induit dans un enroulement secondaire du transformateur (TF1).

14. Procédé selon la revendication 13, dans lequel, pendant la charge et la décharge d'une capacité de charge connectée à la sortie (OUT), l'énergie est renvoyée à la barre omnibus.

15. Procédé selon l'une des revendications 13 ou 14, dans lequel des oscillations sont réduites en fournissant
a. une unité de protection contre les surtensions, en particulier une diode de protection contre les surtensions (D01), et/ou
b. une unité de protection contre les tensions négatives, en particulier une diode de protection contre les tensions négatives (D02) connectée à la sortie (OUT), et
en particulier encore réduit par une première et/ou une seconde résistance d'amortissement (R1, R2) connectées en série aux unités de protection, en particulier aux diodes (D01, D02), respectivement.
